# EUROPEAN PATENT APPLICATION

(11) **EP 4 811 985 A1**
(43) Date of publication of application: **23.09.2026**
(21) Application number: 25800326.8
(22) Date of filing: 09.01.2025
(51) Int. Cl.: H10K 59/12

(54) **DISPLAY PANEL AND DISPLAY DEVICE**

(30) Priority: 06.01.2025 CN 202510018207
(71) Applicant: Wuhan China Star Optoelectronics Semiconductor Display Technology Co., Ltd., Wuhan, Hubei 430079 (CN)
(72) Inventor: WANG, Tongfei, Wuhan, Hubei 430079 (CN); FANG, Hong, Wuhan, Hubei 430079 (CN)
(74) Representative: Studio Torta S.p.A.
(86) International application number: PCT/CN2025/071565
(87) International publication number: WO 2026/143761

(57) **Abstract**

A display panel and a display device are provided by the present disclosure. The display panel includes a display region and a bezel region. The display panel further includes a substrate, at least two signal wiring groups disposed on the substrate, and an organic insulating layer disposed on the signal wiring groups. The signal wiring groups are located in the bezel region. Each of the signal wiring groups includes a plurality of signal wirings arranged at intervals. A linear insulation pattern is provided on the organic insulating layer between adjacent two of the signal wiring groups.

## Description

This application claims priority to and the benefit of Chinese Patent Application No. 202510018207.X, filed on January 6, 2025. The disclosure of which is incorporated herein by reference in its entirety.

### TECHNICAL FIELD

The present disclosure relates to the field of display technologies, and in particular, to a display panel and a display device.

### BACKGROUND

Active matrix organic light-emitting diode (AMOLED) display panels have gradually become a new generation of display technologies due to their characteristics such as high contrast, wide color gamut, and low power consumption. Compared with conventional liquid crystal display (LCD) panels, the organic light-emitting diode display panels are easy to be flexible, which are key technologies for wearable and foldable products. With the development of the organic light-emitting diode display technologies, how to compress bezels while ensuring the reliability of the display panels is an urgent problem to be solved by various screen suppliers.

### SUMMARY

At present, in order to avoid a reliability problem of a display panel, a wire on array (WOA) region generally uses high-low voltage differential groups to separate signal wirings, so as to prevent corrosion of the signal wirings. However, since a width of a bezel of the display panel is compressed, a space of the WOA region is limited, and a distance between the high-low voltage differential groups is insufficient. The WOA region still has the problem of corrosion of the signal wirings caused by electrochemical corrosion between high-low voltage signal wirings, resulting in decrease of the reliability of the display panel.

Therefore, the present disclosure provides a display panel and a display device to improve this defect.

In a first aspect, a display panel is provided by embodiments of the present disclosure. The display panel includes:
a display region and a bezel region disposed on a side of the display region. The display panel further includes:
a substrate;
at least two signal wiring groups arranged at intervals on the substrate and located in the bezel region, where each of the signal wiring groups includes a plurality of signal wirings arranged at intervals, and signal types transmitted by any adjacent two of the signal wiring groups are different; and
an organic insulating layer disposed on the signal wiring groups.

The organic insulating layer is provided with at least one linear insulation pattern. The linear insulation pattern is provided between adjacent two of the signal wiring groups to insulate and separate the adjacent two of the signal wiring groups.

In a second aspect, a display device is further provided by the embodiments of the present disclosure. The display device includes the above-described display panel.

### BRIEF DESCRIPTION OF THE DRAWINGS

In order to more clearly describe the technical solutions in the embodiments, the accompanying drawings used for describing the embodiments will be briefly introduced below. Apparently, the accompanying drawings described below are the merely some of the disclosed embodiments. For a person with ordinary skills in the art, without expenditure of creative labor, other drawings can be derived on the basis of these drawings.
FIG. 1 is a top view of a display panel according to the embodiments of the present disclosure.
FIG. 2 is a schematic enlarged view of part a in FIG. 1.
FIG. 3 is a schematic enlarged view of part b in FIG. 2.
FIG. 4 is a cross-sectional view of a display panel along an A-A' direction according to the embodiments of the present disclosure.
FIG. 5 is a schematic view of a structure of a display device according to the embodiments of the present disclosure.

### DETAILED DESCRIPTION

The following description of the embodiments is made with reference to the accompanying drawings to illustrate specific embodiments in which the present disclosure may be implemented. Apparently, the described embodiments are only a part of but not all embodiments of the present disclosure. Based on the embodiments in the present disclosure, all other embodiments that can be derived by those skilled in the art without creative efforts are within the scope of protection of the present disclosure.

In the description of the present disclosure, it should be understood that the orientations or positional relationships indicated by the terms "upper" and "lower" are based on the orientations or positional relationships shown in the drawings, and the above orientations or positional relationships are only for the convenience of describing the present disclosure and simplifying the description, but do not indicate or imply that the device or element must have a specific orientation, be constructed and operated in a specific orientation, and thus should not be construed as limiting the present disclosure. In addition, terms such as "first" and "second" are used herein for purposes of description, and should not be interpreted as indication or implication of relative importance, or implied indication of a number of the technical features. Thus, features defined by "first" and "second" may explicitly or implicitly include one or more of the features. In the description of the present disclosure, "a plurality of" means two or more than two, unless otherwise expressly and specifically limited.

In the present disclosure, reference numbers and/or reference letters can be repeated in different embodiments, such repetition is for the purposes of simplicity and clarity and does not itself indicate a relationship between the various embodiments and/or arrangements discussed.

Embodiments of the present disclosure provide a display panel and a display device, which can solve the problem of corrosion of signal wirings and improve the reliability of the display panel.

In order to achieve the above-described object, according to a first aspect of the present disclosure, a display panel is provided. The display panel includes:
a display region and a bezel region disposed on a side of the display region. The display panel further includes:
a substrate;
at least two signal wiring groups arranged at intervals on the substrate and located in the bezel region, where each of the signal wiring groups includes a plurality of signal wirings arranged at intervals, and signal types transmitted by any adjacent two of the signal wiring groups are different; and
an organic insulating layer disposed on the signal wiring group.

The organic insulating layer is provided with at least one linear insulation pattern. The linear insulation pattern is provided between adjacent two of the signal wiring groups to insulate and separate the adjacent two of the signal wiring groups.

Optionally, the signal wiring groups includes a first signal wiring sub-group and a second signal wiring sub-group. The first signal wiring sub-group is configured for transmitting a direct current high-voltage signal. The second signal wiring sub-group is configured for transmitting a direct current low-voltage signal. The linear insulation pattern is provided between the first signal wiring sub-group and the second signal wiring sub-group.

Optionally, the first signal wiring sub-group includes a plurality of first signal wirings, and a line width of at least one of the plurality of first signal wirings is less than line widths of other ones of the plurality of first signal wirings.

Optionally, the plurality of first signal wirings include a light-emitting control signal line, and a line width of the light-emitting control signal line is less than the line widths of the other ones of the plurality of first signal wirings.

Optionally, the line width of the light-emitting control signal line ranges from 15 µm to 25 µm, and the line widths of the other ones of the plurality of first signal wirings each range from 40 µm to 80 µm.

Optionally, the second signal wiring sub-group includes a plurality of second signal wirings, and a line width of at least one of the plurality of second signal wirings is less than line widths of other ones of the plurality of second signal wirings.

Optionally, the second signal wiring sub-group includes a light-emitting initial signal line and a light-emitting output signal line, and a line width of at least one of the light-emitting initial signal line and the light-emitting output signal line is less than the line widths of the other ones of the plurality of second signal wirings.

Optionally, the line width of at least one of the light-emitting initial signal line and the light-emitting output signal line ranges from 15 µm to 25 µm, and the line widths of the other ones of the plurality of second signal wirings each range from 40 µm to 80 µm.

Optionally, the signal wiring groups further includes a third signal wiring sub-group configured for transmitting an alternating current signal. The third signal wiring sub-group is disposed on a side of the first signal wiring sub-group away from the second signal wiring sub-group. The linear insulation pattern is provided between the first signal wiring sub-group and the third signal wiring sub-group.

Optionally, the third signal wiring sub-group includes a plurality of third signal wirings. A line width of each of the plurality of third signal wirings is greater than or equal to the line widths of the signal wirings in the first signal wiring sub-group and the second signal wiring sub-group.

Optionally, the bezel region includes a first wiring region, a bending region, a second wiring region, and a terminal region. The first wiring region is disposed between the display region and the bending region. The second wiring region is disposed between the bending region and the terminal region.

At least two of the signal wiring groups and the linear insulation pattern located between the adjacent two of the signal wiring groups are disposed in the first wiring region; and/or at least two of the signal wiring groups and the linear insulation pattern located between the adjacent two of the signal wiring groups are disposed in the first wiring region are disposed in the second wiring region.

Optionally, the display panel further includes at least two connection line groups in one-to-one correspondence with the signal wiring groups. The connection line groups are arranged between the bending region and the terminal region. The connection line groups and the signal wiring groups are arranged in different layers. Each of the connection line groups includes a plurality of connection lines arranged at intervals. One end of each of the plurality of connection lines is configured to be connected to an integrated circuit chip, and another end of each of the plurality of connection lines is connected to a corresponding one of the plurality of signal wirings.

Optionally, the display panel includes:
a gate layer disposed on the substrate; and
a source-drain layer disposed on a side of the gate layer away from the substrate.

The connection line groups are disposed in the gate layer, and the signal wiring groups are disposed in the source-drain layer.

Optionally, the gate layer includes a first gate sub-layer and a second gate sub-layer. The first gate sub-layer is disposed on the substrate. The second gate sub-layer is disposed on a side of the first gate sub-layer away from the substrate. One of any adjacent two of the plurality of connection lines is disposed in the first gate sub-layer, and another of the any adjacent two of the plurality of connection lines is disposed in the second gate sub-layer.

Optionally, the linear insulation pattern includes a groove, and the groove extends along an extending direction of the signal wirings.

Optionally, the organic insulating layer includes:
a first planarization layer disposed on a side of the source-drain layer away from the gate layer; and
a second planarization layer disposed on a side of the first planarization layer away from the source-drain layer.

Along a film thickness direction of the organic insulating layer, the groove penetrates through the first planarization layer and the second planarization layer.

Optionally, the display panel further includes an inorganic insulating layer, and the inorganic insulating layer is continuously disposed on a surface of the organic insulating layer, a sidewall and a bottom of the groove.

According to a second aspect of the present disclosure, a display device is provided. The display device includes the above-described display panel.

In the display panel of the embodiments of the present disclosure, the signal wirings in the bezel region are divided into at least two signal wiring groups arranged at intervals and transmitting different signal types. The organic insulating layer between adjacent two of the signal wiring groups is provided with the linear insulation pattern, so that the adjacent two of the signal wiring groups are insulated and separated by the linear insulation pattern to prevent electrochemical corrosion between the adjacent two of the signal wiring groups transmitting different signal types, thereby reducing the risk of corrosion of the signal wirings in the bezel region and improving the reliability of the display panel.

The embodiments of the present disclosure provide the display panel. The display panel includes the substrate, the at least two signal wiring groups arranged at intervals, and the organic insulating layer. The signal wiring groups are arranged on the substrate and located in the bezel region. Each of the signal wiring groups includes the plurality of signal wirings arranged at intervals. The signal types transmitted by any adjacent two of the signal wiring groups are different. The organic insulating layer is disposed on the signal wiring groups. The organic insulating layer is provided with the linear insulation pattern. The linear insulation pattern is provided between adjacent two of the signal wiring groups to insulate and separate the signal wiring groups.

In the embodiments of the present disclosure, the signal wirings in the bezel region are divided into at least two signal wiring groups arranged at intervals and transmitting different signal types. The organic insulating layer between adjacent two of the signal wiring groups is provided with the linear insulation pattern, so that the adjacent two of the signal wiring groups are insulated and separated by the linear insulation pattern to prevent electrochemical corrosion between the adjacent two of the signal wiring groups transmitting different signal types, thereby reducing the risk of corrosion of the signal wirings in the bezel region and improving the reliability of the display panel.

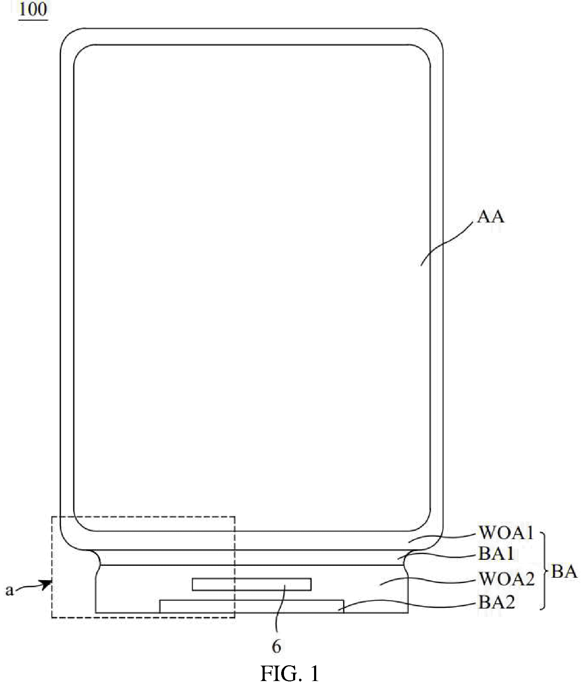

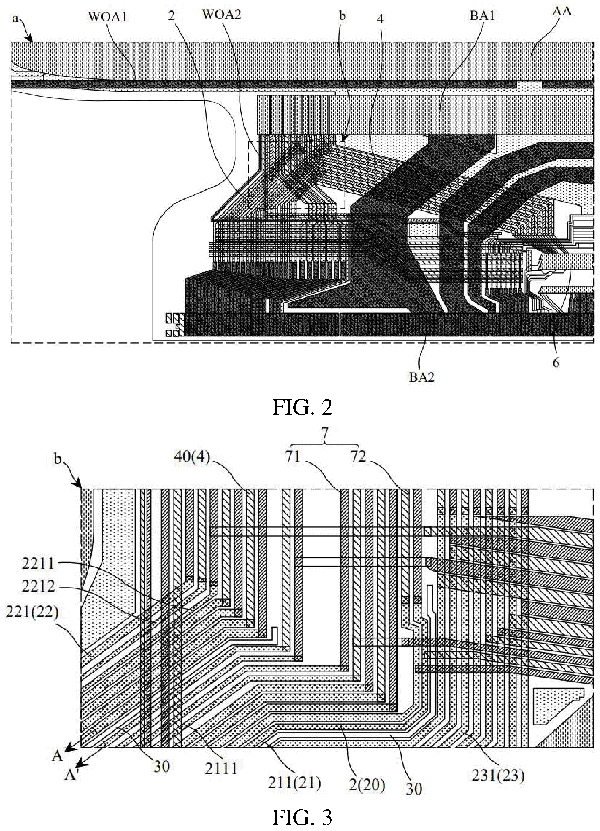

Referring to FIG. 1 and FIG. 2, FIG. 1 is a top view of a display panel according to the embodiments of the present disclosure, and FIG. 2 is a schematic enlarged view of part a in FIG. 1. The display panel 100 includes a display region AA and a bezel region BA disposed on a side of the display region AA.

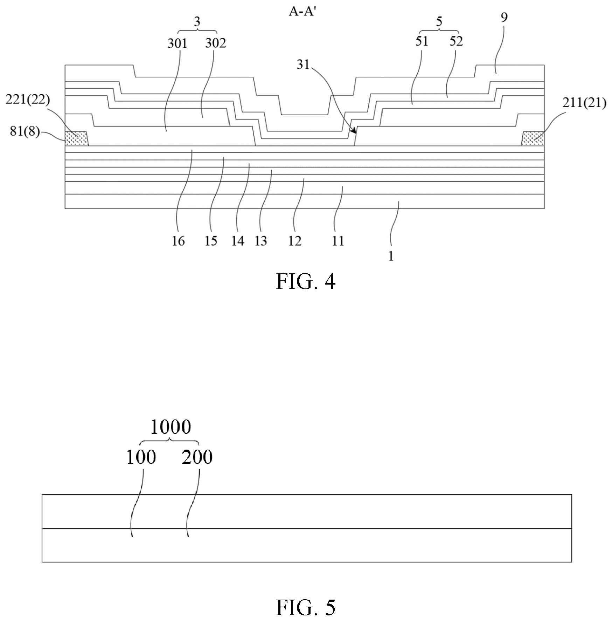

Referring to FIG. 3 and FIG. 4, FIG. 3 is a schematic enlarged view at part b in FIG. 2, and FIG. 4 is a cross-sectional view of a display panel along an A-A' direction according to the embodiments of the present disclosure. The display panel 100 includes a substrate 1, at least two signal wiring groups 2 arranged at intervals, and an organic insulating layer 3. The signal wiring groups 2 are arranged on the substrate 1 and located in the bezel region BA. Each of the signal wiring groups 2 includes a plurality of signal wirings 20 arranged at intervals. Signal types transmitted by any adjacent two of the signal wiring groups 2 are different. The organic insulating layer 3 is disposed on the signal wiring groups 2. The organic insulating layer 3 is provided with a linear insulation pattern 30. The linear insulation pattern 30 is provided between adjacent two of the signal wiring groups 2 to insulate and separate the adjacent two of the signal wiring groups 2. This can not only avoid signal crosstalk of the signal wirings for transmitting different signal types, but also prevent electrochemical corrosion between adjacent two of the signal wiring groups for transmitting different signal types, thereby reducing the risk of corrosion of the signal wirings in the bezel region and improving the reliability of the display panel.

It should be noted that the signal types may include a voltage level characteristic and a direction characteristic of signals. Each of the signal wiring groups 2 is configured to transmit the signals having corresponding characteristics, so as to realize accurate classification and efficient transmission of the signals.

In some embodiments, referring to FIG. 3 and FIG. 4, the signal wiring groups 2 include a first signal wiring sub-group 21 and a second signal wiring sub-group 22. The first signal wiring sub-group 21 is spaced apart from the second signal wiring sub-group 22. The first signal wiring sub-group 21 is configured for transmitting a direct current high-voltage signal. The second signal wiring sub-group 22 is configured for transmitting a direct current low-voltage signal. The linear insulation pattern 30 is provided between the first signal wiring sub-group 21 and the second signal wiring sub-group 22.

In some embodiments, referring to FIG. 3 and FIG. 4, the linear insulation pattern 30 includes a groove 31. The groove 31 extends along an extending direction of the signal wirings 20. The groove 31 separates the organic insulating layer 3 above the first signal wiring sub-group 21 from the organic insulating layer 3 above the second signal wiring sub-group 22, so as to prevent water vapor from penetrating through the organic insulating layer 3 above the first signal wiring sub-group 21 to the organic insulating layer above the second signal wiring sub-group 22. Thus, an electrochemical corrosion path between the first signal wiring sub-group 21 and the second signal wiring sub-group 22 may be cut off, thereby reducing the risk of electrochemical corrosion of the first signal wiring sub-group 21 and the second signal wiring sub-group 22.

In some embodiments, referring to FIG. 3, the first signal wiring sub-group 21 includes a plurality of first signal wirings 211. The plurality of first signal wirings 211 are arranged side by side at intervals. A line width of at least one of the first signal wirings 211 is less than line widths of other ones of the first signal wirings 211. The line widths of some of the first signal wirings 211 are compressed to increase a distance between the first signal wiring sub-group 21 and the second signal wiring sub-group 22. As such, this not only reduces the risk of crosstalk between the first signal wiring sub-group 21 and the second signal wiring sub-group 22, but also facilitates that the groove 31 is disposed on the organic insulating layer 3 between the first signal wiring sub-group 21 and the second signal wiring sub-group 22 Thus, the organic insulating layer 3 above the first signal wiring sub-group 21 is separated from the organic insulating layer 3 above the second signal wiring sub-group 22 by using the groove 31, thereby reducing the risk of electrochemical corrosion between the first signal wiring sub-group 21 and the second signal wiring sub-group 22.

In some embodiments, referring to FIG. 3, the first signal wiring sub-group 21 includes a light-emitting control signal line 2111. A line width of the light-emitting control signal line 2111 is less than the line widths of the other ones of the first signal wirings 211. The line width of the light-emitting control signal line 2111 is compressed to increase the distance between the first signal wiring sub-group 21 and the second signal wiring sub-group 22. As such, this not only reduces the risk of crosstalk between the first signal wiring sub-group 21 and the second signal wiring sub-group 22, but also facilitates that the linear insulation pattern 30 is disposed on the organic insulating layer 3 between the first signal wiring sub-group 21 and the second signal wiring sub-group 22. Thus, the organic insulating layer 3 above the first signal wiring sub-group 21 is separated from the organic insulating layer 3 above the second signal wiring sub-group 22 by using the linear insulation pattern 30, thereby reducing the risk of electrochemical corrosion of the first signal wiring sub-group 21 and the second signal wiring sub-group 22.

Referring to FIG. 2, the line width of the light-emitting control signal line 2111 ranges from 15 µm to 25 µm. The line widths of the other ones of the plurality of first signal wirings 211 each range from 40 µm to 85 µm.

In some embodiments, the first signal wirings 211 may further include, but is not limited to, a gate high voltage signal line and an analog signal line. The light-emitting control signal line 2111, the gate high voltage signal line, and the analog signal line all transmit direct current high-voltage signals.

In some embodiments, referring to FIG. 3, the second signal wiring sub-group 22 includes a plurality of second signal wirings 221. The plurality of second signal wirings 221 are arranged side by side at intervals. A line width of at least one of the second signal wirings 221 is less than line widths of other ones of the second signal wirings 221. The line width of some of the second signal wirings 221 is compressed to increase the distance between the first signal wiring sub-group 21 and the second signal wiring sub-group 22. As such, this can not only reduce the risk of crosstalk between the first signal wiring sub-group 21 and the second signal wiring sub-group 22, but also facilitates that the linear insulation pattern 30 is disposed on the organic insulating layer 3 between the first signal wiring sub-group 21 and the second signal wiring sub-group 22. Thus, the organic insulating layer 3 above the first signal wiring sub-group 21 is separated from the organic insulating layer 3 above the second signal wiring sub-group 22 by using the linear insulation pattern 30, thereby reducing the risk of electrochemical corrosion of the first signal wiring sub-group 21 and the second signal wiring sub-group 22.

In some embodiments, the second signal wiring sub-group 22 includes a light-emitting initial signal line 2211 and a light-emitting output signal line 2212. A line width of at least one of the light-emitting initial signal line 2211 and the light-emitting output signal line 2212 is less than the line widths of the other ones of the second signal wirings 221.

Referring to FIG. 3, the line width of at least one of the light-emitting initial signal line 2211 and the line width of the light-emitting output signal line 2212 ranges from 15 µm to 25 µm. The line widths of the other ones of the second signal wirings 221 each range from 40 µm to 85 µm.

In some embodiments, the second signal wirings 221 may further include, but is not limited to, a gate low voltage signal line. The light-emitting initial signal line 2211, the light-emitting output signal line 2212, and the gate low voltage signal line all transmit direct current low-voltage signals.

In some embodiments, referring to FIG. 3, the signal wiring groups 2 further include a third signal wiring sub-group 23. The third signal wiring sub-group 23 is configured for transmitting an alternating current signal. The third signal wiring sub-group 23 is disposed on a side of the first signal wiring sub-group 21 away from the second signal wiring sub-group 22. The linear insulation pattern 30 is provided between the first signal wiring sub-group 21 and the third signal wiring sub-group 23.

Referring to FIG. 2 and FIG. 3, the groove 31 separates the organic insulating layer 3 above the first signal wiring sub-group 21 from the organic insulating layer 3 above the third signal wiring sub-group 23 to prevent water vapor from penetrating through the organic insulating layer 3 above the first signal wiring sub-group 21 to the organic insulating layer above the third signal wiring sub-group 23. Thus, an electrochemical corrosion path between the first signal wiring sub-group 21 and the third signal wiring sub-group 23 may be cut off, thereby reducing the risk of electrochemical corrosion of the first signal wiring sub-group 21 and the third signal wiring sub-group 23.

In some embodiments, referring to FIG. 3, the third signal wiring sub-group 23 includes a plurality of third signal wirings 231. A line width of each of the third signal wirings 231 is greater than or equal to the line widths of the signal wirings in the first signal wiring sub-group 21 and the second signal wiring sub-group 22.

In some embodiments, referring to FIG. 1, FIG. 2, and FIG. 3, the bezel region BA includes a first wiring region WOA1, a bending region BA1, a second wiring region WOA2, and a terminal region BA2. The first wiring region WOA1 is disposed between the display region AA and the bending region BA1. The second wiring region WOA2 is disposed between the bending region BA1 and the terminal region BA2. At least two of the signal wiring groups 2 and the linear insulation pattern 30 located between the adjacent two of the signal wiring groups 2 are disposed in the first wiring region WOA1; and/or at least two of the signal wiring groups 2 and the linear insulation pattern 30 located between the adjacent two of the signal wiring groups 2 are disposed in the second wiring region WOA2.

In some embodiments, referring to FIG. 1 to FIG. 4, the second wiring region WOA2 is provided with the first signal wiring sub-group 21, the second signal wiring sub-group 22, and the third signal wiring sub-group 23. The linear insulation pattern 30 is provided between adjacent two of the signal wiring groups 2, so that the risk of electrochemical corrosion of the signal wirings in the second wiring region WOA2 can be reduced.

In some other embodiments, the first wiring region WOA1 may also be provided with at least two of the signal wiring groups 2 and the linear insulation pattern 30 located between adjacent two of the signal wiring groups 2. The arrangement of the signal wiring groups 2 and the linear insulation pattern 30 may refer to the arrangement of the second wiring region WOA2 shown in FIG. 3, which will not be repeated herein.

In some embodiments, referring to FIG. 3, the display panel 100 further includes at least two connection line groups 4 in one-to-one correspondence with the signal wiring groups 2. The connection line groups 4 are disposed between the bending region BA1 and the terminal region BA2. Each of the connection line groups 4 includes a plurality of connection lines 40 arranged at intervals. The connection line groups 4 and the signal wiring groups 2 are arranged in different layers. One end of each of the connection lines 40 is configured to be connected to an integrated circuit chip 6, another end of each of the connection lines 40 is connected to one end of a corresponding one of the signal wirings 20, and another end of each of the signal wirings 20 is connected to a terminal of the terminal region BA2. The terminal of the terminal region BA2 is configured to be bonded to a flexible circuit board. In the second wiring region WOA2, each of the signal wirings 20 is connected to a corresponding one of the connection lines 40 through a via hole, so as to realize wire changing in the second wiring region WOA2.

In some embodiments, referring to FIG. 3 and FIG. 4, the display panel 100 includes a gate layer 7 and a source-drain layer 8. The gate layer 7 is disposed on the substrate 1. The source-drain layer 8 is disposed on a side of the gate layer 7 away from the substrate 1. The connection wiring groups 4 are disposed in the gate layer 7. The signal wiring groups 2 are disposed in the source-drain layer 8.

In some embodiments, referring to FIG. 3 and FIG. 4, the gate layer 7 includes a first gate layer 71 and a second gate layer 72. The first gate layer 71 is disposed on the substrate 1. The second gate layer 72 is disposed on a side of the first gate layer 71 away from the substrate 1. One of any adjacent two of the connection lines is disposed in the first gate layer 71, and another of the any adjacent two of the connection lines is disposed in the second gate layer 72.

In some embodiments, referring to FIG. 3 and FIG. 4, the source-drain layer 8 includes a first source-drain layer 81 and a second source-drain layer (not shown in the figure). The first source-drain layer 81 is disposed on a side of the second gate layer 72 away from the first gate layer 71. The second source-drain layer is disposed on a side of the first source-drain layer away from the second gate layer 72. The signal wiring groups 2 are disposed in the first source-drain layer 81.

In some embodiments, the organic insulating layer 3 includes a first planarization layer 301 and a second planarization layer 302. The first planarization layer 321 is disposed on a side of the source-drain layer away from the gate layer. The second planarization layer 302 is disposed on a side of the first planarization layer 301 away from the source-drain layer. The groove 31 penetrates through the first planarization layer 301 and the second planarization layer 302.

In some embodiments, referring to FIG. 4, the display panel 100 further includes an inorganic insulating layer 5. The inorganic insulating layer 5 is continuously disposed on a surface of the organic insulating layer 3, and a sidewall and a bottom of the groove 31. The surface of the organic insulating layer 3 and the sidewall and the bottom of the groove 31 are covered by the inorganic insulating layer 5. The inorganic insulating layer has a good ability of blocking water and oxygen, which can further prevent water vapor from penetrating through the organic insulating layer 3 above the first signal wiring sub-group 21 to the organic insulating layer above the second signal wiring sub-group 22 or the third signal wiring sub-group 23. As such, the electrochemical corrosion path between the first signal wiring sub-group 21 and the second signal wiring sub-group 22 or the third signal wiring sub-group 23 can be cut off, thereby reducing the risk of electrochemical corrosion of the first signal wiring sub-group 21 and the second signal wiring sub-group 22 or the third signal wiring sub-group 23.

In some embodiments, referring to FIG. 4, the inorganic insulating layer 5 includes a first inorganic insulating layer 51 and a second inorganic insulating layer 52 in a stacked configuration. The first inorganic insulating layer 51 and the second inorganic insulating layer 52 both belong to a part of a touch layer. A first touch insulating layer and a second touch insulating layer in the touch layer extend to the bezel region BA to form the first inorganic insulating layer 51 and the second inorganic insulating layer 52.

In some embodiments, referring to FIG. 4, the display panel 100 further includes a covering layer 9. The covering layer 9 is disposed on a surface of the inorganic insulating layer 5 away from the substrate 1.

In some embodiments, referring to FIG. 4, the display panel 100 further includes a buffer layer 11, a first gate insulating layer 12, a second gate insulating layer 13, a first interlayer dielectric layer 14, a second interlayer dielectric layer 15, and a passivation layer 16 stacked on the substrate 1.

According to the display panel provided by the above-described embodiments of the present disclosure, the embodiments of the present disclosure further provide a display device. Referring to FIG. 5, FIG. 5 is a schematic view of a structure of the display device according to the embodiments of the present disclosure. The display device 1000 includes the display panel 100 and a housing 200. The display panel 100 is disposed on the housing 200. The display panel 100 may be the display panel provided by any of the above-described embodiments. The display device provided by the embodiments of the present disclosure can achieve the same technical effects as the display panel provided by any of the above-described embodiments, which will not be repeated herein.

Beneficial effects of the embodiments of the present disclosure are as follows. The embodiments of the present disclosure provide the display panel and the display device. The display panel includes the display region and the bezel region. The display panel further includes the substrate, the at least two signal wiring groups disposed on the substrate, and the organic insulating layer disposed on the signal wiring groups. The signal wiring groups are located in the bezel region. Each of the signal wiring groups includes a plurality of signal wirings arranged at intervals. The signal types transmitted by any adjacent two of the signal wiring groups are different. The signal wirings in the bezel region are divided into at least two signal wiring groups arranged at intervals and transmitting different signal types. The organic insulating layer between adjacent two of the signal wiring groups is provided with the linear insulation pattern, so that the adjacent two of the signal wiring groups are insulated and separated by the linear insulation pattern to prevent electrochemical corrosion between the adjacent two of the signal wiring groups transmitting different signal types, thereby reducing the risk of corrosion of the signal wirings in the bezel region and improving the reliability of the display panel.

In the description of the present disclosure, terms such as "first" and "second" are used herein for purposes of description, and should not be interpreted as indication or implication of relative importance, or implied indication of a number of the technical features. Thus, features defined by "first" and "second" may explicitly or implicitly include one or more of the features. In the description of the present disclosure, "a plurality of" means two or more than two, unless otherwise expressly and specifically limited.

In the above embodiments, different parts of the technical solution are given different levels of description in different embodiments, and some features that are not specified in a particular embodiment can be found in the relevant descriptions of other embodiments.

The embodiments, implementations, and related technical features of the present disclosure can be combined and replaced with each other without conflict.

The above embodiments are merely preferred embodiments of the present disclosure, and do not limit the present disclosure in any form. Any simple modifications, equivalent changes, and modifications made to the above embodiments according to the technical essence of the present disclosure without departing from the content of the technical proposal of the present disclosure still fall within the scope of the technical proposal of the present disclosure.

## Claims

1. A display panel, comprising a display region and a bezel region disposed on a side of the display region; wherein the display panel further comprises:
a substrate;
at least two signal wiring groups arranged at intervals on the substrate and located in the bezel region, wherein each of the signal wiring groups comprises a plurality of signal wirings arranged at intervals, and signal types transmitted by any adjacent two of the signal wiring groups are different; and
an organic insulating layer disposed on the signal wiring groups;
wherein the organic insulating layer is provided with at least one linear insulation pattern, and the linear insulation pattern is provided between adjacent two of the signal wiring groups to insulate and separate the adjacent two of the signal wiring groups.

2. The display panel according to claim 1, wherein the signal wiring groups comprise a first signal wiring sub-group and a second signal wiring sub-group, the first signal wiring sub-group is configured for transmitting a direct current high-voltage signal, the second signal wiring sub-group is configured for transmitting a direct current low-voltage signal, and the linear insulation pattern is provided between the first signal wiring sub-group and the second signal wiring sub-group.

3. The display panel according to claim 2, wherein the first signal wiring sub-group comprises a plurality of first signal wirings, and a line width of at least one of the plurality of first signal wirings is less than line widths of other ones of the plurality of first signal wirings.

4. The display panel according to claim 3, wherein the plurality of first signal wirings comprise a light-emitting control signal line, and a line width of the light-emitting control signal line is less than the line widths of the other ones of the plurality of first signal wirings.

5. The display panel according to claim 4, wherein the line width of the light-emitting control signal line ranges from 15 µm to 25 µm, and the line widths of the other ones of the plurality of first signal wirings each range from 40 µm to 80 µm.

6. The display panel according to claim 2, wherein the second signal wiring sub-group comprises a plurality of second signal wirings, and a line width of at least one of the plurality of second signal wirings is less than line widths of other ones of the plurality of second signal wirings.

7. The display panel according to claim 6, wherein the second signal wiring sub-group comprises a light-emitting initial signal line and a light-emitting output signal line, and a line width of at least one of the light-emitting initial signal line and the light-emitting output signal line is less than the line widths of the other ones of the plurality of second signal wirings.

8. The display panel according to claim 7, wherein the line width of at least one of the light-emitting initial signal line and the light-emitting output signal line ranges from 15 µm to 25 µm, and the line widths of the other ones of the plurality of second signal wirings each range from 40 µm to 80 µm.

9. The display panel according to claim 2, wherein the signal wiring groups further comprise a third signal wiring sub-group configured for transmitting an alternating current signal, the third signal wiring sub-group is disposed on a side of the first signal wiring sub-group away from the second signal wiring sub-group, and the linear insulation pattern is provided between the first signal wiring sub-group and the third signal wiring sub-group.

10. The display panel according to claim 9, wherein the third signal wiring sub-group comprises a plurality of third signal wirings, and a line width of each of the plurality of third signal wirings is greater than or equal to the line widths of the signal wirings in the first signal wiring sub-group and the second signal wiring sub-group.

11. The display panel according to any one of claims 2 to 10, wherein the bezel region comprises a first wiring region, a bending region, a second wiring region, and a terminal region, the first wiring region is disposed between the display region and the bending region, and the second wiring region is disposed between the bending region and the terminal region; and wherein at least two of the signal wiring groups and the linear insulation pattern located between the adjacent two of the signal wiring groups are disposed in the first wiring region; and/or at least two of the signal wiring groups and the linear insulation pattern located between the adjacent two of the signal wiring groups are disposed in the first wiring region.

12. The display panel according to claim 11, wherein the display panel further comprises at least two connection line groups in one-to-one correspondence with the signal wiring groups, the connection line groups are arranged between the bending region and the terminal region, and the connection line groups and the signal wiring groups are arranged in different layers; and wherein each of the connection line groups comprises a plurality of connection lines arranged at intervals, one end of each of the plurality of connection lines is configured to be connected to an integrated circuit chip, and another end of each of the plurality of connection lines is connected to a corresponding one of the plurality of signal wirings.

13. he display panel according to claim 12, wherein the display panel further comprises:
a gate layer disposed on the substrate; and
a source-drain layer disposed on a side of the gate layer away from the substrate;
wherein the connection line groups are disposed in the gate layer, and the signal wiring groups are disposed in the source-drain layer.

14. The display panel according to claim 13, wherein the gate layer comprises a first gate sub-layer and a second gate sub-layer, the first gate sub-layer is disposed on the substrate, the second gate sub-layer is disposed on a side of the first gate sub-layer away from the substrate, one of any adjacent two of the plurality of connection lines is disposed in the first gate sub-layer, and another of the any adjacent two of the plurality of connection lines is disposed in the second gate sub-layer.

15. The display panel according to claim 13, wherein the linear insulation pattern comprises a groove, and the groove extends along an extending direction of the plurality of signal wirings.

16. The display panel according to claim 15, wherein the organic insulating layer comprises:
a first planarization layer disposed on a side of the source-drain layer away from the gate layer; and
a second planarization layer disposed on a side of the first planarization layer away from the source-drain layer;
wherein along a film thickness direction of the organic insulating layer, the groove penetrates through the first planarization layer and the second planarization layer.

17. The display panel according to claim 16, wherein the display panel further comprises an inorganic insulating layer, and the inorganic insulating layer is continuously disposed on a surface of the organic insulating layer, and a sidewall and a bottom of the groove.

18. A display device, comprising the display panel according to any one of claims 1 to 17.
